(19) Europäisches Patentamt
European Patent Office
Office européen des brevets

(11) EP 4 012 911 A1

(12) EUROPEAN PATENT APPLICATION
published in accordance with Art. 153(4) EPC

(43) Date of publication:
15.06.2022 Bulletin 2022/24

(21) Application number: 21845927.9

(22) Date of filing: 16.01.2021

(51) International Patent Classification (IPC):
H02M 3/335 (2006.01)    G01R 19/00 (2006.01)

(52) Cooperative Patent Classification (CPC):
Y02B 70/10

(86) International application number:
PCT/CN2021/072339

(87) International publication number:
WO 2022/016835 (27.01.2022 Gazette 2022/04)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 20.07.2020 CN 202010699920

(71) Applicant: Huazhong University of Science and
Technology
Wuhan
Hubei 430074 (CN)

(72) Inventors:
• LIU, Yang
Wuhan, Hubei 430074 (CN)
• WANG, Weikang
Wuhan, Hubei 430074 (CN)

(74) Representative: Becker, Eberhard
Becker Kurig & Partner
Patentanwälte mbB
Bavariastraße 7
80336 München (DE)

(54) **CURRENT MEASUREMENT METHOD AND APPARATUS FOR LLC RESONANT CONVERTER**

(57) The disclosure discloses a current detection method and device of an LLC resonant converter, and belongs to the technical field of switching power supplies of power electronics, and the method comprises the steps: decomposing a resonant current of the LLC resonant converter into a superposed form of a sine component and cosine component; arranging the output current of the LLC resonant converter into an expression $i_d(t)$ of the resonant current and the exciting current of the LLC resonant converter; in the operation process of the LLC resonant converter, sampling the output current once at any moment t' in a half resonant period, obtaining a relation between the resonant current and the exciting current at the moment t', and combining the relation with the relation that the resonant current and the exciting current are equal at the starting moment of the half resonant period; and solving to obtain amplitudes of two components of the resonant current, and substituting the amplitudes into the expression $i_d(t)$ to obtain a waveform expression of the output current of the LLC resonant converter in one switching period. According to the disclosure, real-time and accurate detection of the current of the LLC resonant converter can be realized, and the dynamic performance of a subsequent control algorithm is improved.

decomposing a resonant current $i_r$ of the LLC resonant converter into a superposed form of a sine component and a cosine component, arranging an output current $i_d$ of the LLC resonant converter into an expression $i_d(t)$ of the resonant current $i_r$ and an exciting current $i_m$ of the LLC resonant converter

↓

in an operation process of the LLC resonant converter, sampling the output current $i_d$ once at any moment t' in a half resonant period, thereby obtaining a sampled current value $i_d(t')$, thereby obtaining a relation between the resonant current $i_r$ and the exciting current $i_m$ at the moment t'

↓

combining a relation that the resonant current $i_r$ and the exciting current $i_m$ are equal at a starting moment of the half resonant period with the relation between the resonant current $i_r$ and the exciting current $i_m$ at the moment t', solving the relation equations to obtain amplitudes of the sine component and the cosine component of the resonant current $i_r$, substituting the amplitudes into the expression $i_d(t)$ to obtain a waveform expression of the output current $i_d$ of the LLC resonant converter in a switching period to which the half resonant period belongs

FIG. 3

**Description**

BACKGROUND

Field of the Disclosure

The disclosure belongs to the technical field of switching power supplies of power electronics, and more specifically, relates to a current detection method and device of an LLC resonant converter.

Description of Related Art

In order to adapt to the trend of miniaturization of switching power supplies, power semiconductor devices have been developed with high frequency, because for switching power supplies, the most effective way to reduce the size and increase the power density is to increase the switching frequency. In recent years, the third-generation wide-bandgap semiconductors can greatly improve the performance of power supply devices because of their extraordinary characteristics such as high switching frequency and low driving loss. Therefore, they have been widely adopted in the field of switching power supplies. Since LLC resonant converters can achieve soft switching in the full load range to reduce switching losses, the structure is simple and efficient, and is very compatible with the characteristics of third-generation semiconductors, LLC resonant converters using third-generation semiconductors have become a popular topic for research.

No matter in the case of precise closed-loop control of a single-phase LLC resonant converter or precise current sharing control of a multi-phase LLC resonant converter, accurate and fast current feedback information is required. With the application and promotion of third-generation semiconductors, the switching frequency of LLC resonant converters has increased to hundreds of kHz or even MHz level, and the output current waveform of the rectifier circuit on the secondary side of the transformer when the LLC resonant converter is operating is twice the half-wave waveform of the switching frequency, and the amplitude of current ripple is large. The ultra-high switching frequency and the characteristics of LLC itself make it difficult for ordinary current detection methods to obtain accurate and instant output current information of LLC resonant converters, that is, it is difficult to acquire the transient load of LLC resonant converters. Therefore, it is a challenge to carry out precise control of the LLC resonant converter which operates under high frequency and current sharing control of the interleaved parallel LLC resonant converter.

Before the popularization and application of third-generation semiconductors, the switching frequency of LLC resonant converters was generally low. In order to obtain current information when the converter is operating, the converter is usually sampled with high frequency current 5-10 times per period, thereby estimating the current waveform of each period. In occasions where there is no high requirement for instant current information, it is also possible to perform low-pass filtering and sampling of the high-frequency half-wave current through the low-pass filter circuit, thereby estimating the actual waveform through the sampled low-pass current value. However, clearly the problem with such method is that the dynamic characteristics are poor, and there is hysteresis in current sampling, which will have a negative impact on algorithms that require high dynamic characteristics, especially when the operation condition of converter is unstable.

SUMMARY OF THE DISCLOSURE

In view of the defects and requirements of improvement of conventional technology, the disclosure provides a current detection method and device for LLC resonant converter, which aims to solve the technical problem that the existing current detection methods of high-frequency LLC resonant converter cannot accurately obtain the current information of LLC resonant converter in real time.

In order to achieve the above purpose, according to one aspect of the disclosure, a current detection method of LLC resonant converter is provided, which includes:

A resonant current $i_r$ of the LLC resonant converter is decomposed into a superposed form of a sine component and a cosine component. The output current $i_d$ of the LLC resonant converter is arranged into an expression $i_d(t)$ of the resonant current $i_r$ and an exciting current $i_m$ of the LLC resonant converter.

In the operation process of the LLC resonant converter, the output current $i_d$ is sampled once at any moment t' in a half resonant period, thereby obtaining a sampled current value $i_d$(t'). In this way, a relation between the resonant current $i_r$ and the exciting current $i_m$ at the moment t' is obtained.

The relation that the resonant current $i_r$ and the exciting current $i_m$ are equal at the starting moment of the half resonant period are combined with the relation between the resonant current $i_r$ and the exciting current $i_m$ at the moment t'. The relation equations are solved to obtain amplitudes of a sine component and a cosine component of the resonant current $i_r$, the amplitudes are substituted into the expression $i_d(t)$ to obtain a waveform expression of the output current

$i_d$ of the LLC resonant converter in the switching period that belongs to the half resonant period.

The disclosure decomposes the resonant current $i_r$ of the LLC resonant converter into a superposed form of a sine component and a cosine component, so that the expression of the resonant current $i_r$ only contains two unknown quantities, namely the sine component amplitude and the cosine component amplitude. After the output current $i_d$ is arranged into the expression $i_d(t)$ of the resonant current $i_r$ and the exciting current $i_m$ of the LLC resonant converter, since the exciting current $i_m$ is only related to the known parameters such as the structure parameters and output voltage of the LLC resonant converter, there are still only two unknown quantities in the expression $i_d(t)$. Since the resonant current $i_r$ and the exciting current $i_m$ are in an equal relationship at the starting moment of the half resonant period, it is only necessary to sample the output current $i_d$ once to obtain the relation between the resonant current $i_r$ and the exciting current $i_m$ at another moment. By combining the two relation equations, the two unknown quantities in the equation of the output voltage can be solved, thereby obtaining the waveform expression of the output current $i_d(t)$ in the corresponding switching period. In the disclosure, there is no need to perform multiple times of sampling in the process of detecting the current of the LLC resonant converter, and there is no complicated fitting process. In this way, the disclosure can realize instant and accurate current detection and improve the dynamic performance of the subsequent control algorithm.

Further, after arranging the output current $i_d$ of the LLC resonant converter into the expression $i_d(t)$ of the resonant current $i_r$ and the exciting current $i_m$ of the LLC resonant converter, the expression $i_d(t)$ is as follows.

$$i_d(t) = N|i_r(t) - i_m(t)|$$

In the expression, N represents the turns ratio between the primary side and the secondary side of the transformer in the LLC resonant converter, and t represents the time variable.

In some alternative embodiments, the half resonant period during which the output current $i_d$ is sampled is the first half resonant period in one switching period.

Further, after decomposing the resonant current $i_r$ of the LLC resonant converter into the superposed form of the sine component and cosine component, the expression of the resonant current $i_r$ is as follows.

$$i_r(t) = I_{r1} \sin\left(\frac{2\pi t}{t_r}\right) + I_{r2} \cos\left(\frac{2\pi t}{t_r}\right)$$

In the expression, $I_{r1}$ and $I_{r2}$ respectively represent the amplitudes of the sine component and cosine component of the resonant current after decomposition, $t_r$ represents the resonant period of the LLC resonant converter, and t represents the time variable.

Further, the expression for the exciting current $i_m$ of the LLC resonant converter is as follows.

$$i_m(t) = \frac{NV_o(4t - t_r)}{4L_m}$$

In the expression, N represents the turns ratio between the primary side and the secondary side of the transformer in the LLC resonant converter, $V_o$ represents the output voltage of the LLC resonant converter, $t_r$ represents the resonant period of the LLC resonant converter, $L_m$ represents the magnetizing inductance of the transformer in the LLC resonant converter, and t represents the time variable.

In some alternative embodiments, the half resonant period during which the output current $i_d$ is sampled is the second half resonant period in one switching period.

Further, after decomposing the resonant current $i_r$ of the LLC resonant converter into the superposed form of the sine component and cosine component, the expression of the resonant current $i_r$ is as follows.

$$i_r(t) = -I_{r1} \sin\left(\frac{2\pi t}{t_r}\right) - I_{r2} \cos\left(\frac{2\pi t}{t_r}\right)$$

In the expression, $I_{r1}$ and $I_{r2}$ respectively represent the amplitudes of the sine component and cosine component of the resonant current after decomposition, $t_r$ represents the resonant period of the LLC resonant converter, and t represents the time variable.

Further, the expression for the exciting current $i_m$ of the LLC resonant converter is as follows.

$$i_m(t) = -\frac{NV_o(4t - t_r)}{4L_m}$$

In the expression, N represents the turns ratio between the primary side and the secondary side of the transformer in the LLC resonant converter, $V_o$ represents the output voltage of the LLC resonant converter, $t_r$ represents the resonant period of the LLC resonant converter, $L_m$ represents the magnetizing inductance of the transformer in the LLC resonant converter, and t represents the time variable.

Further, the current detection method of LLC resonant converter provided by the disclosure further includes the following.

A waveform expression of the output current $i_d$ of the LLC resonant converter in the switching period that belongs to the half resonant period is used to calculate the peak value and/or effective value of the output current $i_d$ in the corresponding switching period.

According to another aspect of the disclosure, a current detection device of an LLC resonant converter is provided, including: a sampling unit and a calculation unit.

The calculation unit is used to decompose the resonant current $i_r$ of the LLC resonant converter into the superposed form of the sine component and cosine component, and then arrange the output current $i_d$ of the LLC resonant converter into the expression $i_d(t)$ of the resonant current $i_r$ and the exciting current $i_m$ of the LLC resonant converter.

The sampling unit is used to sample the output current $i_d$ once at any moment t' in the half resonant period during the operation of the LLC resonant converter to obtain the sampled current value $i_d(t')$, thereby obtaining the relation between the resonant current $i_r$ and the exciting current $i_m$ at the moment t'.

The calculation unit is further used to combine the relation that the resonant current $i_r$ and the exciting current $i_m$ are equal at the starting moment of the half resonant period with the relation between the resonant current $i_r$ and the exciting current $i_m$ at the moment t', solve the equations to obtain amplitudes of the sine component and the cosine component of the resonant current $i_r$, substitute the amplitudes into the expression $i_d(t)$ to obtain a waveform expression of the output current $i_d$ of the LLC resonant converter in the switching period that belongs to the half resonant period.

In general, through the above technical solutions conceived in the disclosure, the following advantageous effects can be achieved.

(1) Through a single acquisition of transient current and theoretical analysis, the disclosure can instantly calculate the real-time output current in each switching period when the LLC converter is operated under high frequency. In this way, the dynamic characteristics and response speed of the control algorithm of LLC converter can be improved, which helps to precisely control the LLC resonant converter under high-frequency operating conditions.

(2) The disclosure only needs to sample a current sampling chip whose sampling speed matches the LLC switching frequency, thereby realizing sampling of a single transient current and completing current detection without adding a complicated sampling circuit. The requirement for hardware is low, and the cost is low as well.

BRIEF DESCRIPTION OF THE DRAWINGS

FIG. 1 is a schematic diagram of the structure of an existing LLC resonant converter.

FIG. 2 is a schematic waveform diagram of the switching signal, resonant current $i_r$, exiting current $i_m$ and the output current $i_d$ at the end of the rectifier circuit of the existing LLC resonant converter; wherein (a) is a schematic waveform diagram of the switching signal of the LLC resonant converter, (b) is a schematic waveform diagram of the resonant current $i_r$ and the exiting current $i_m$ of the LLC resonant converter, and (c) is a schematic waveform diagram of the output current $i_d$ at the end of the rectifier circuit of the LLC resonant converter.

FIG. 3 is a schematic diagram of a current detection method of an LLC resonant converter provided by an embodiment of the disclosure.

DESCRIPTION OF EMBODIMENTS

In order to make the objectives, technical solutions, and advantages of the present disclosure clearer, the following further describes the present disclosure in detail with reference to the accompanying drawings and embodiments. It should be understood that the specific embodiments described here are only used to explain the present disclosure, but not used to limit the present disclosure. In addition, the technical features involved in the various embodiments of the present disclosure described below can be combined with each other as long as they do not conflict with each other.

In the present disclosure, the terms "first", "second", etc. (if any) in the present disclosure and the accompanying drawings are used to distinguish similar objects, and are not necessarily used to describe a specific sequence or order.

Before explaining the technical scheme of the present disclosure in detail, the structure of the LLC resonant converter and its operating principle will be briefly introduced as follows.

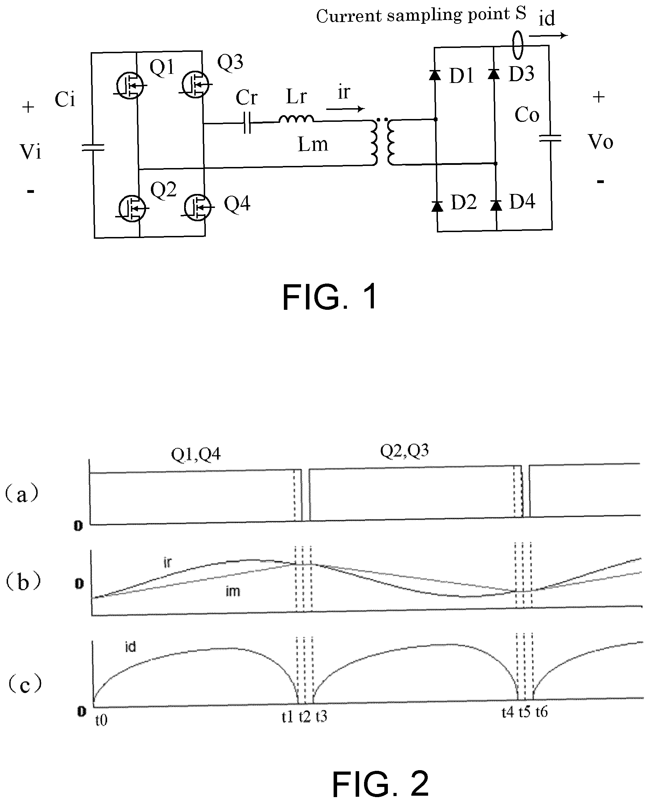

The structure of LLC resonant converter is shown in FIG. 1. The circuit structure of LLC resonant converter includes: an input filter capacitor $C_i$, an inverter bridge composed of four switch tubes ($Q_1Q_2Q_3Q_4$), a resonant inductor $L_r$, a resonant capacitor $C_r$, a transformer T, a rectifier circuit composed of four diodes ($D_1D_2D_3D_4$) and an output filter capacitor $C_o$. At the end of the rectifier circuit (such as the sampling point S shown in FIG. 1) is the output current $i_d$ of the LLC resonant converter.

The duration of one switching period of the LLC resonant converter is $t_s = 2t_2$, and the resonant period of the LLC resonant converter is $t_s = 2t_2$. In the following embodiments, the LLC resonant converter operates in the operating

$$t_r = \frac{1}{2\pi\sqrt{L_rC_r}}$$

interval of $t_s > t_r$. The expression of the resonant period $t_r$ is specifically .

After injecting the driving current into the LLC resonant converter shown in FIG. 1, the LLC resonant converter starts to operate. During operation, the waveform diagrams of the switching signal, resonant current $i_r$, exiting current $i_m$ and the output current $i_d$ at the end of the rectifier circuit is as shown in FIG. 2.

As shown in (a) of FIG. 2, at time $t_0$, that is, at the starting moment of a switching period (the starting moment of the first half of the resonant period), the switching tubes $Q_1$ and $Q_4$ are turned on. Since the resonant current $i_r$ before turning on is less than 0, $Q_1$ and $Q_4$ are in the reverse-conducting freewheeling state, so the voltages at both ends of $Q_1$ and $Q_4$ are in the clamp state. As such, $Q_1$ and $Q_4$ can be zero-voltage-switching (ZVS) at the moment $t_0$ The resonant current $i_r$ flows through $Q_1$ and $Q_4$, $L_r$ and $C_r$ begin to resonate. Because the transformer is clamped by the secondary side, the exciting current $i_m$ rises approximately linearly. The voltage direction on the secondary side of the transformer is positive and negative, and the current flows through the rectifier diodes $D_1$ and $D_4$ to supply energy for the load.

As shown in (b) of FIG. 2, at the moment $t_1$, at the end of the first half of the resonant period, the resonant current $i_r$ is equal to the exciting current $i_m$, so the energy exchange between the primary side and the secondary side of the transformer is disconnected, and the current on the secondary side drops rapidly to 0. Then, the rectifier diodes $D_1$ and $D_4$ achieve zero current switching, and the current at the secondary side $i_o$=0. Due to the turn-off of the rectifier circuit, the clamping of the primary side of the transformer is eliminated. Under the circumstances, the magnetizing inductance $L_m$ and the resonant inductance $L_r$ of the transformer resonate together with the resonant capacitor $C_r$ to generate resonance. Because the magnetizing inductance $L_m$ of the transformer is far greater than the resonant inductance $L_r$, the resonant angular velocity $\omega_r$ of the three mentioned above is much smaller than the resonant angular velocity in the period $t_0$ - $t_1$ . Therefore, the resonant current $i_r$ and exciting current $i_m$ are approximately unchanged under the circumstances.

Because the existing current detection method for LLC resonant converter needs to carry out sampling for multiple times and estimate the current waveform of various switching periods based on the sampling results, it is difficult to accurately and instantly detect the current of LLC resonant converter operating in high-frequency condition. To solve the above problem, the disclosure provides a current detection method and device for LLC resonant converter. The overall idea is that based on the operating principle of LLC resonant converter, the output current expression of LLC resonant converter is transformed through theoretical derivation, so that only one current sampling is required, and combining with the known conditions in the LLC resonant converter, it is possible to solve the current waveform of the output current of the LLC resonant converter in various switching periods.

Based on the above ideas, the disclosure makes the following derivation based on the operating principle of LLC resonant converter.

$u_C$ and $u_L$ respectively represent the voltages of the resonant capacitor $C_r$ and the resonant inductor $L_r$, and $I_{1,ini}$ and $V_{1,ini}$ respectively represent the initial values of the resonant current $i_r$ and voltage $u_C$ at the moment $t_0$, that is,

$$\begin{cases} u_C(t_0) = V_{1,ini} \\ i_r(t_0) = I_{1,ini} \end{cases}$$

.

$$\begin{cases} u_C + u_L + NV_o = V_i \\ u_L = L_r\frac{di_r}{dt} \\ i_r = C_r\frac{du_C}{dt} \end{cases}$$

Because ;

$$\begin{cases} u_C = I_{1,ini}\sqrt{\frac{L_r}{C_r}}\sin\omega_r t + (V_{1,ini} + NV_o - V_i)\cos\omega_r t + (V_i - NV_o) \\ \\ i_r = \omega_r C_r\left(I_{1,ini}\sqrt{\frac{L_r}{C_r}}\cos\omega_r t - (V_{1,ini} + NV_o - V_i)\sin\omega_r t\right) \\ \\ u_L = -L_r C_r \omega_r^{2}\left(I_{1,ini}\sqrt{\frac{L_r}{C_r}}\sin\omega_r t + (V_{1,ini} + NV_o - V_i)\cos\omega_r t\right) \end{cases}$$

can be obtained.

Exciting current $i_m = I_{1,ini} + \frac{NV_o t}{L_m}$ .

In the expression, $V_i$ represents the input voltage of the LLC resonant converter, $V_o$ represents the output voltage of the LLC resonant converter, and N represents the turns ratio between the primary side and the secondary side of the transformer T.

Since the resonant current $i_r$ and exciting current $i_m$ are approximately unchanged during the time period $t_0$ - $t_1$, it is known that in the time period $t_0$ - $t_1$, $i_m(t) = i_r(t) = i_m(t_1) = i_r(t_1)$. As shown in FIG. 2(b), the waveform changes in the time period $t_3$ - $t_4$ (that is, in the second half of the resonant period) have the same size and opposite direction compared with the time period $t_0$ - $t_1$, that is, $i_m(t_3) = i_r(t_3) = i_m(t_0) = i_r(t_0) = -I_{1,ini}$, that is, $I_{1,ini} = -\frac{NV_o t_1}{2L_m}$ .

Based on the above analysis, it can be obtained through calculation that in the time period $t_0$ - $t_1$, exciting current $i_m(t) = \frac{NV_o(4t - t_r)}{4L_m}$ . According to the expression, it is known that in the time period $t_0$ - $t_1$, the exciting current is only related to known parameters such as the structure parameters and output voltage of the LLC resonant converter.

Assume $i_r(t) = I_{r1}\sin\left(\frac{2\pi t}{t_r}\right) + I_{r2}\cos\left(\frac{2\pi t}{t_r}\right)$ , the output current of the LLC resonant converter is $i_d(t)$ = $N|i_r(t) - i_m(t)|$. Since the resonant current at the moment $t_0$ is equal to the exciting current, $i_r(t_0) = i_m(t_0)$. The output current $i_d(t)$ is sampled at any moment t' within the time period $t_0$ - $t_1$ to obtain the sampled current value $i_d(t') = N|i_r(t')$ - $i_m(t')|$ at the moment t'.

The two equations are combined to calculate the two variables $I_{r1}$ and $I_{r2}$ in $i_r(t) = I_{r1}\sin\left(\frac{2\pi t}{t_r}\right) + I_{r2}\cos\left(\frac{2\pi t}{t_r}\right)$ , from which the waveform expression of $i_d(t)$ in this switching period can be calculated, thereby deriving the transient load of the LLC resonant converter in this period.

In the time period $t_3$ - $t_4$ (that is, in the second half of the resonant period), the waveform changes of the exciting current $i_m(t)$ and the resonant current $i_r(t)$ have the same size and opposite direction as compared with the time period $t_0$ - $t_1$. As shown in FIG. 2(c), in the time period $t_3$ - $t_4$, the waveform change of the output current $i_d(t)$ is the same as the time period $t_0$ - $t_1$. Therefore, in the time period $t_3$ - $t_4$, $i_m(t) = -\frac{NV_o(4t - t_r)}{4L_m}$ , $i_r(t) = -I_{r1}\sin\left(\frac{2\pi t}{t_r}\right) - I_{r2}\cos\left(\frac{2\pi t}{t_r}\right)$ , and $i_d(t) = N|i_r(t) - i_m(t)|$. Similarly, at time $t_3$, $i_r(t_3) = i_m(t_3)$, the output current $i_d(t)$ is sampled at any moment t' within the time period $t_3$ - $t_4$ to obtain the sampled current value $i_d(t') = N|i_r(t')$ - $i_m(t')|$ at the moment t'. The two equations are combined, and the two variables $I_{r1}$ and $I_{r2}$ can be calculated. In this way, the waveform expression of $i_d(t)$ in this switching period can be calculated.

The following are embodiments.

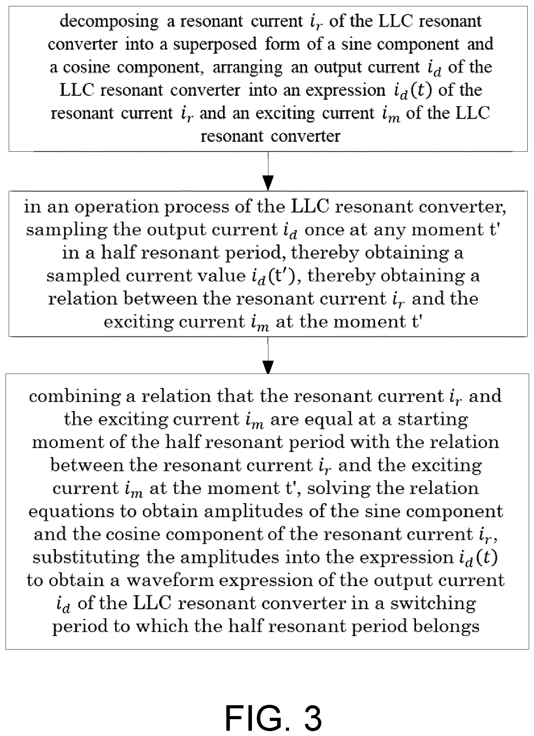

First embodiment:
A current detection method of LLC resonant converter, as shown in FIG. 3, includes the following.

A resonant current $i_r$ of the LLC resonant converter is decomposed into a superposed form of a sine component and a cosine component. The output current $i_d$ of the LLC resonant converter is arranged into an expression $i_d(t)$ of the resonant current $i_r$ and an exciting current $i_m$ of the LLC resonant converter.

In the operation process of the LLC resonant converter, the output current $i_d$ is sampled once at any moment t' in a half resonant period, thereby obtaining a sampled current value $i_d(t')$. In this way, a relation between the resonant

current $i_r$ and the exciting current $i_m$ at the moment t' is obtained.

The relation that the resonant current $i_r$ and the exciting current $i_m$ are equal at the starting moment of the half resonant period are combined with the relation between the resonant current $i_r$ and the exciting current $i_m$ at the moment t'. The relation equations are solved to obtain amplitudes of a sine component and a cosine component of the resonant current $i_r$, the amplitudes are substituted into the expression $i_d(t)$ to obtain a waveform expression of the output current $i_d$ at the end of the rectifier circuit of the LLC resonant converter in the switching period that belongs to the half resonant period.

In this embodiment, the half resonant period for sampling the output current is the first half resonant period in a switching period, that is, the time period $t_0$ - $t_1$ shown in FIG. 2. The current sampling point is the end of the rectifier circuit of the LLC resonant converter, that is, the current sampling point S in FIG. 1.

In the embodiment,

$$\begin{cases} i_d(t) = N|i_r(t) - i_m(t)| \\ i_m(t) = \frac{NV_o(4t - t_r)}{4L_m} \\ i_r(t) = I_{r1}\sin\left(\frac{2\pi t}{t_r}\right) + I_{r2}\cos\left(\frac{2\pi t}{t_r}\right) \end{cases}$$

is combined with

$$\begin{cases} i_r(t_0) = i_m(t_0) \\ i_d(t') = N|i_r(t') - i_m(t')| \end{cases}.$$

The two equations are solved to obtain the amplitudes $I_{r1}$ and $I_{r2}$ of the sine component and cosine component of the resonant current $i_r$, and the amplitudes are substituted into the expression $i_d(t)$ to obtain that the waveform expression of the output current of the LLC resonant converter in a switching period is as follows.

$$i_d(t) = N\left|I_{r1}\sin\left(\frac{2\pi t}{t_r}\right) + I_{r2}\cos\left(\frac{2\pi t}{t_r}\right) - \frac{NV_o(4t - t_r)}{4L_m}\right|$$

Based on the waveform expression of the output current of the LLC resonant converter in a switching period, the transient load of the LLC resonant converter in this period can be derived.

As an alternative implementation manner, this embodiment further includes the following.

According to the waveform expression of the output current $i_d$ at the end of the rectifier circuit in the LLC resonant converter in the switching period that belongs to the half resonant period, the peak value and/or effective value of the output current $i_d$ in the corresponding switching period are calculated.

In general, this embodiment can instantly calculate the real-time output current of various switching periods when the LLC converter is operated in the high-frequency condition through a single acquisition of transient currents and theoretical analysis, thereby improving the dynamic characteristics and response speed of the control algorithm of the LLC converter, which helps to precisely control the LLC resonant converter operating under high-frequency condition.

Second embodiment:

A current detection method for an LLC resonant converter. This embodiment is similar to the first embodiment above, except that in this embodiment, the half resonant period during which the output current is sampled is the second half resonant period within a switching period, that is, the time period $t_3$ - $t_4$ shown in FIG. 2.

In the embodiment,

$$\begin{cases} i_d(t) = N|i_r(t) - i_m(t)| \\ i_m(t) = -\frac{NV_o(4t - t_r)}{4L_m} \\ i_r(t) = -I_{r1}\sin\left(\frac{2\pi t}{t_r}\right) - I_{r2}\cos\left(\frac{2\pi t}{t_r}\right) \end{cases}$$

is combined with

$$\begin{cases} i_r(t_3) = i_m(t_3) \\ i_d(t') = N|i_r(t') - i_m(t')| \end{cases}.$$

The two equations are solved to obtain the amplitudes $I_{r1}$ and $I_{r2}$ of the sine component and cosine component of the resonant current $i_r$, and the amplitudes are substituted into the expression $i_d(t)$ to obtain that the waveform expression of the output current of the LLC resonant converter in a switching period is as follows.

$$i_d(t) = N \left| I_{r1} \sin\left(\frac{2\pi t}{t_r}\right) + I_{r2} \cos\left(\frac{2\pi t}{t_r}\right) - \frac{NV_o(4t - t_r)}{4L_m} \right|$$

Based on the waveform expression of the output current of the LLC resonant converter in a switching period, the transient load of the LLC resonant converter in this period can be derived.

Third embodiment:

A current detection device of LLC resonant converter includes a sampling unit and a calculation unit.

The calculation unit is used to decompose the resonant current $i_r$ of the LLC resonant converter into the superposed form of the sine component and cosine component, and then arrange the output current $i_d$ of the LLC resonant converter into the expression $i_d(t)$ of the resonant current $i_r$ and the exciting current $i_m$ of the LLC resonant converter.

The sampling unit is used to sample the output current $i_d$ once at any moment t' in the half resonant period during the operation of the LLC resonant converter to obtain the sampled current value $i_d(t')$, thereby obtaining the relation between the resonant current $i_r$ and the exciting current $i_m$ at the moment t'. The sampling unit may be a current sampling chip whose sampling speed matches the switching frequency.

The calculation unit is further used to combine the relation that the resonant current $i_r$ and the exciting current $i_m$ are equal at the starting moment of the half resonant period with the relation between the resonant current $i_r$ and the exciting current $i_m$ at the moment t', solve the equations to obtain amplitudes of the sine component and the cosine component of the resonant current $i_r$, substitute the amplitudes into the expression $i_d(t)$ to obtain a waveform expression of the output current $i_d$ at the end of the rectifier circuit of the LLC resonant converter in the switching period that belongs to the half resonant period.

In this embodiment, for the specific implementation of each module, please refer to the description in the above method embodiment, and no further description is incorporated herein.

Those skilled in the art can easily understand that the above are only preferred embodiments of the present disclosure and are not intended to limit the present disclosure. Any modification, equivalent replacement and improvement, etc. made within the spirit and principle of the present disclosure should fall within the scope to be protected by the present disclosure.

**Claims**

1. A current detection method of an LLC resonant converter, **characterized in** comprising:

   decomposing a resonant current $i_r$ of the LLC resonant converter into a superposed form of a sine component and a cosine component, arranging an output current $i_d$ of the LLC resonant converter into an expression $i_d(t)$ of the resonant current $i_r$ and an exciting current $i_m$ of the LLC resonant converter; in an operation process of the LLC resonant converter, sampling the output current $i_d$ once at any moment t' in a half resonant period, thereby obtaining a sampled current value $i_d(t')$, thereby obtaining a relation between the resonant current $i_r$ and the exciting current $i_m$ at the moment t';
   combining a relation that the resonant current $i_r$ and the exciting current $i_m$ are equal at a starting moment of the half resonant period with the relation between the resonant current $i_r$ and the exciting current $i_m$ at the moment t', solving the relation equations to obtain amplitudes of the sine component and the cosine component of the resonant current $i_r$, substituting the amplitudes into the expression $i_d(t)$ to obtain a waveform expression of the output current $i_d$ of the LLC resonant converter in a switching period that belongs to the half resonant period.

2. The current detection method of the LLC resonant converter according to claim 1, **characterized in that** after arranging the output current $i_d$ of the LLC resonant converter into the expression $i_d(t)$ of the resonant current $i_r$ and the exciting current $i_m$ of the LLC resonant converter, the expression $i_d(t)$ is as follows:

$$i_d(t) = N|i_r(t) - i_m(t)|$$

   wherein N represents a turns ratio between a primary side and a secondary side of a transformer in the LLC resonant converter, and t represents a time variable.

3. The current detection method of the LLC resonant converter according to claim 1 or 2, **characterized in that** the half resonant period during which the output current $i_d$ is sampled is a first half resonant period in one switching period.

4. The current detection method of the LLC resonant converter according to claim 3, wherein after decomposing the resonant current $i_r$ of the LLC resonant converter into the superposed form of the sine component and cosine component, the expression of the resonant current $i_r$ is as follows:

$$i_r(t) = I_{r1} \sin\left(\frac{2\pi t}{t_r}\right) + I_{r2} \cos\left(\frac{2\pi t}{t_r}\right)$$

wherein $I_{r1}$ and $I_{r2}$ respectively represent the amplitudes of the sine component and cosine component of the resonant current after decomposition, $t_r$ represents the resonant period of the LLC resonant converter, and t represents the time variable.

5. The current detection method of the LLC resonant converter according to claim 3, **characterized in that** the expression for the exciting current $i_m$ of the LLC resonant converter is as follows:

$$i_m(t) = \frac{NV_o(4t - t_r)}{4L_m}$$

wherein N represents the turns ratio between the primary side and the secondary side of the transformer in the LLC resonant converter, $V_o$ represents an output voltage of the LLC resonant converter, $t_r$ represents the resonant period of the LLC resonant converter, $L_m$ represents a magnetizing inductance of the transformer in the LLC resonant converter, and t represents the time variable.

6. The current detection method of the LLC resonant converter according to claim 1 or 2, **characterized in that** the half resonant period during which the output current $i_d$ is sampled is a second half resonant period in one switching period.

7. The current detection method of the LLC resonant converter according to claim 6, **characterized in that** after decomposing the resonant current $i_r$ of the LLC resonant converter into the superposed form of the sine component and cosine component, the expression of the resonant current $i_r$ is as follows:

$$i_r(t) = -I_{r1} \sin\left(\frac{2\pi t}{t_r}\right) - I_{r2} \cos\left(\frac{2\pi t}{t_r}\right)$$

wherein $I_{r1}$ and $I_{r2}$ respectively represent the amplitudes of the sine component and cosine component of the resonant current after decomposition, $t_r$ represents the resonant period of the LLC resonant converter, and t represents the time variable.

8. The current detection method of the LLC resonant converter according to claim 6, **characterized in that** the expression for the exciting current $i_m$ of the LLC resonant converter is as follows:

$$i_m(t) = -\frac{NV_o(4t - t_r)}{4L_m}$$

wherein N represents the turns ratio between the primary side and the secondary side of the transformer in the LLC resonant converter, $V_o$ represents an output voltage of the LLC resonant converter, $t_r$ represents the resonant period of the LLC resonant converter, $L_m$ represents a magnetizing inductance of the transformer in the LLC resonant converter, and t represents the time variable.

9. The current detection method of the LLC resonant converter according to claim 1 or 2, **characterized in** further comprising:
the waveform expression of the output current $i_d$ of the LLC resonant converter in the switching period that belongs to the half resonant period is used to calculate a peak value and/or an effective value of the output current $i_d$ in a corresponding switching period.

10. A current detection device of an LLC resonant converter, **characterized in** comprising: a sampling unit and a calculation unit;

wherein the calculation unit is used to decompose a resonant current $i_r$ of the LLC resonant converter into a superposed form of a sine component and cosine component, and arrange an output current $i_d$ of the LLC resonant converter into an expression $i_d(t)$ of the resonant current $i_r$ and an exciting current $i_m$ of the LLC resonant converter;

the sampling unit is used to sample the output current $i_d$ once at any moment t' in a half resonant period during an operation process of the LLC resonant converter to obtain a sampled current value $i_d(t')$, thereby obtaining a relation between the resonant current $i_r$ and the exciting current $i_m$ at the moment t';

the calculation unit is further used to combine a relation that the resonant current $i_r$ and the exciting current $i_m$ are equal at a starting moment of the half resonant period with the relation between the resonant current $i_r$ and the exciting current $i_m$ at the moment t', solve the relation equations to obtain amplitudes of the sine component and the cosine component of the resonant current $i_r$, substitute the amplitudes into the expression $i_d(t)$ to obtain a waveform expression of the output current $i_d$ of the LLC resonant converter in a switching period that belongs to the half resonant period.

Current sampling point S   id

# FIG. 1

(a)   Q1,Q4        Q2,Q3

(b)   ir   im

(c)   id

t0        t1 t2 t3        t4 t5 t6

# FIG. 2

decomposing a resonant current $i_r$ of the LLC resonant converter into a superposed form of a sine component and a cosine component, arranging an output current $i_d$ of the LLC resonant converter into an expression $i_d(t)$ of the resonant current $i_r$ and an exciting current $i_m$ of the LLC resonant converter

in an operation process of the LLC resonant converter, sampling the output current $i_d$ once at any moment t' in a half resonant period, thereby obtaining a sampled current value $i_d(t')$, thereby obtaining a relation between the resonant current $i_r$ and the exciting current $i_m$ at the moment t'

combining a relation that the resonant current $i_r$ and the exciting current $i_m$ are equal at a starting moment of the half resonant period with the relation between the resonant current $i_r$ and the exciting current $i_m$ at the moment t', solving the relation equations to obtain amplitudes of the sine component and the cosine component of the resonant current $i_r$, substituting the amplitudes into the expression $i_d(t)$ to obtain a waveform expression of the output current $i_d$ of the LLC resonant converter in a switching period to which the half resonant period belongs

# FIG. 3

## INTERNATIONAL SEARCH REPORT

| International application No. |
| --- |
| **PCT/CN2021/072339** |

**A. CLASSIFICATION OF SUBJECT MATTER**

H02M 3/335(2006.01)i; G01R 19/00(2006.01)i

According to International Patent Classification (IPC) or to both national classification and IPC

**B. FIELDS SEARCHED**

Minimum documentation searched (classification system followed by classification symbols)

H02M, G01R

Documentation searched other than minimum documentation to the extent that such documents are included in the fields searched

Electronic data base consulted during the international search (name of data base and, where practicable, search terms used)

CNPAT, EPODOC, WPI, CNKI: LLC, 谐振变换器, 输出电流, 检测, 谐振电流, 励磁电流, 采样, 正弦, 余弦, 开关周期, converter, resonant, detection, current, excitation, output, sampled, waveform, switching, period

**C. DOCUMENTS CONSIDERED TO BE RELEVANT**

| Category* | Citation of document, with indication, where appropriate, of the relevant passages | Relevant to claim No. |
| --- | --- | --- |
| PX | CN 111884515 A (HUAZHONG UNIVERSITY OF SCIENCE AND TECHNOLOGY) 03 November 2020 (2020-11-03)<br>description, paragraphs [0042]-[0090], and figures 1-3 | 1-10 |
| A | CN 109842302 A (SILERGY SEMICONDUCTOR TECHNOLOGY (HANGZHOU) CO., LTD.) 04 June 2019 (2019-06-04)<br>description, paragraphs [0037]-[0067], and figures 2-6 | 1-10 |
| A | CN 110112926 A (NANJING UNIVERSITY OF AERONAUTICS AND ASTRONAUTICS) 09 August 2019 (2019-08-09)<br>entire document | 1-10 |
| A | CN 108418433 A (SHENZHEN EN-PLUS TECHNOLOGIES CO., LTD.) 17 August 2018 (2018-08-17)<br>entire document | 1-10 |
| A | CN 109639151 A (HANGZHOU SILAN MICROELECTRONICS CO., LTD.) 16 April 2019 (2019-04-16)<br>entire document | 1-10 |
| A | US 2010328968 A1 (STMICROELECTRONICS S.R.L.) 30 December 2010 (2010-12-30)<br>entire document | 1-10 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **31 March 2021** | **15 April 2021** |

| Name and mailing address of the ISA/CN | Authorized officer |
| --- | --- |
| **China National Intellectual Property Administration (ISA/ CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

| | | International application No. |
| --- | --- | --- |
| | | **PCT/CN2021/072339** |

| Patent document cited in search report | | | Publication date (day/month/year) | Patent family member(s) | | | Publication date (day/month/year) |
| --- | --- | --- | --- | --- | --- | --- | --- |
| CN | 111884515 | A | 03 November 2020 | None | | | |
| CN | 109842302 | A | 04 June 2019 | US | 2020267812 | A1 | 20 August 2020 |
| | | | | CN | 109842302 | B | 14 August 2020 |
| CN | 110112926 | A | 09 August 2019 | None | | | |
| CN | 108418433 | A | 17 August 2018 | CN | 207968333 | U | 12 October 2018 |
| | | | | WO | 2019183880 | A1 | 03 October 2019 |
| CN | 109639151 | A | 16 April 2019 | CN | 209389940 | U | 13 September 2019 |
| US | 2010328968 | A1 | 30 December 2010 | US | 9780678 | B2 | 03 October 2017 |
| | | | | US | 2019109543 | A1 | 11 April 2019 |
| | | | | CN | 101951152 | A | 19 January 2011 |
| | | | | US | 2018006568 | A1 | 04 January 2018 |
| | | | | EP | 2299580 | A3 | 27 July 2011 |
| | | | | US | 2020350826 | A1 | 05 November 2020 |
| | | | | US | 10193461 | B2 | 29 January 2019 |
| | | | | EP | 2299580 | A2 | 23 March 2011 |
| | | | | US | 10756637 | B2 | 25 August 2020 |

Form PCT/ISA/210 (patent family annex) (January 2015)